(19) **Europäisches Patentamt**

**European Patent Office**

**Office européen des brevets**

(11) **EP 0 513 085 B2**

(12) **NOUVEAU FASCICULE DE BREVET EUROPEEN**

(45) Date de publication et mention de la décision concernant l'opposition:
**28.02.2001 Bulletin 2001/09**

(45) Mention de la délivrance du brevet:
**10.11.1993 Bulletin 1993/45**

(21) Numéro de dépôt: **91903127.8**

(22) Date de dépôt: **15.01.1991**

(51) Int Cl.⁷: **H03H 9/64**, H03H 9/145

(86) Numéro de dépôt international:
**PCT/FR91/00024**

(87) Numéro de publication internationale:
**WO 91/11856 (08.08.1991 Gazette 1991/18)**

(54) **FILTRE A ONDES ACOUSTIQUES DE SURFACE**

AKUSTISCHE OBERFLÄCHENWELLENFILTER

SURFACE ACOUSTIC WAVE FILTER

(84) Etats contractants désignés:
**DE GB**

(30) Priorité: **02.02.1990 FR 9001227**

(43) Date de publication de la demande:
**19.11.1992 Bulletin 1992/47**

(73) Titulaire: **THOMSON-CSF**
**75008 Paris (FR)**

(72) Inventeur: **DUFILIE, Pierre**
**F-06650 Le Rouret (FR)**

(74) Mandataire: **Desperrier, Jean-Louis et al Thomson-CSF Propriété Intellectuelle, 13, Avenue du Président Salvador Allende 94117 Arcueil Cédex (FR)**

(56) Documents cités:
**US-A- 3 662 293**

• **Patent Abstracts of Japan, volume 9, No. 318 (E-366)(2041), 13 December 1985**
• **Patent Abstracts of Japan, volume 9, No. 193 (E-334)(1916), 09 August 1985**

## Description

La présente invention se rapporte à un filtre à ondes acoustiques de surface.

Un filtre hyperfréquences à ondes acoustiques de surface comporte, dans le mode de réalisation le plus simple de ce genre de filtre, un transducteur d'entrée connecté électriquement à la borne d'entrée du filtre et un transducteur de sortie qui est placé sur le même substrat pièzoélectrique que ce transducteur d'entrée de façon à être relié acoustiquement directement (c'est à dire sans aucun obstacle) à ce dernier et qui est connecté électriquement à la borne de sortie du filtre.

Si l'on désire durcir les spécifications d'un tel filtre, il s'avère nécessaire d'augmenter la longueur du substrat (c'est à dire d'augmenter la distance qui correspond au trajet acoustique direct entre ces deux transducteurs) afin d'allonger la durée de sa réponse impulsionnelle. Il est en effet bien connu qu'un filtre de bande à ondes acoustiques de surface a une réponse d'autant meilleure que sa réponse impulsionnelle est longue (le filtre idéal est celui qui aurait une réponse impulsionnelle de durée infinie). Cette solution classique a cependant pour inconvénient d'augmenter exagérément l'encombrement de ce filtre et par conséquent de pénaliser plus que souhaité son coût de fabrication.

Il est connu du document "Patent Abstracts of Japan, volume 9, n° 318(E-366)[2041], 13 décembre 1985 et JP-A, 60-150312 (TOSHIBA), 8 août 1985" un filtre à ondes acoustiques de surface constitué selon une structure bi-voies comprenant chacune respectivement un transducteur d'entrée connecté électriquement à la borne d'entrée du filtre et au moins un transducteur de sortie connecté électriquement à la borne de sortie ledit transducteur d'entrée étant directement connecté acoustiquement audit transducteur de sortie, lesdits transducteurs de sortie étant décalés l'un par rapport à l'autre de $(n+\frac{1}{4})\lambda$. Il n'y a pas de réflecteur (mais un autre transducteur de sortie) connecté acoustiquement au transducteur d'entrée de chacune des voies.

Il est également connu du brevet US-A-3 662 293 un dispositif à ondes acoustiques de surface comprenant un transducteur d'entrée, un transducteur de sortie et un réflecteur (20) décalé de λ/4 par rapport au transducteur de sortie.

Ces deux dispositifs ont seulement pour but de supprimer les réflections parasites, notamment l'écho de triple transit. Aucun ne pose le problème de l'allongement de la durée de la réponse impulsionnelle.

Pour remédier à ces inconvénients, l'invention propose un filtre à ondes acoustiques de surface selon la revendication 1.

De façon préférentielle, les deux transducteurs d'entrée de ce filtre sont identiques et sont des transducteurs de type court, c'est à dire non pondérés.

Avantageusement, les distances qui séparent chacun des transducteurs d'entrée du transducteur de sortie qui lui est acoustiquement associé sont égales.

Les transducteurs de sortie sont préférentiellement des transducteurs pondérés de type long, dont les pondérations respectives sont choisies pour conférer au filtre la courbe de réponse impulsionnelle souhaitée.

Les deux transducteurs d'entrée sont, toujours de manière préférentielle, symétriques par rapport à l'axe longitudinal du filtre.

Quant aux deux transducteurs de sortie, il s'agit avantageusement de transducteurs de mêmes dimensions, et ils sont préférentiellement disposés symétriquement par rapport à l'axe longitudinal du filtre.

De toute façon, l'invention sera bien comprise, et ses avantages et autres caractéristiques ressortiront, lors de la description suivante de quelques exemples non limitatifs de réalisation, en référence au dessin schématique annexé dans lequel :

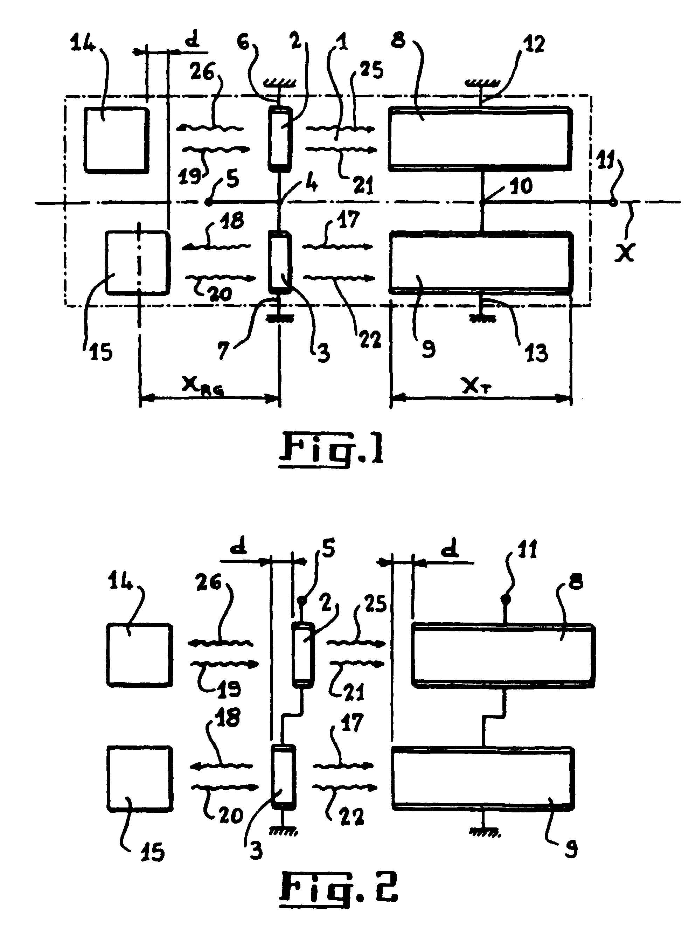

. Figure 1 est une première forme de réalisation de filtre hyperfréquences à ondes acoustiques de surface ;

. Figure 2 est une variante du filtre de la figure 1 ;

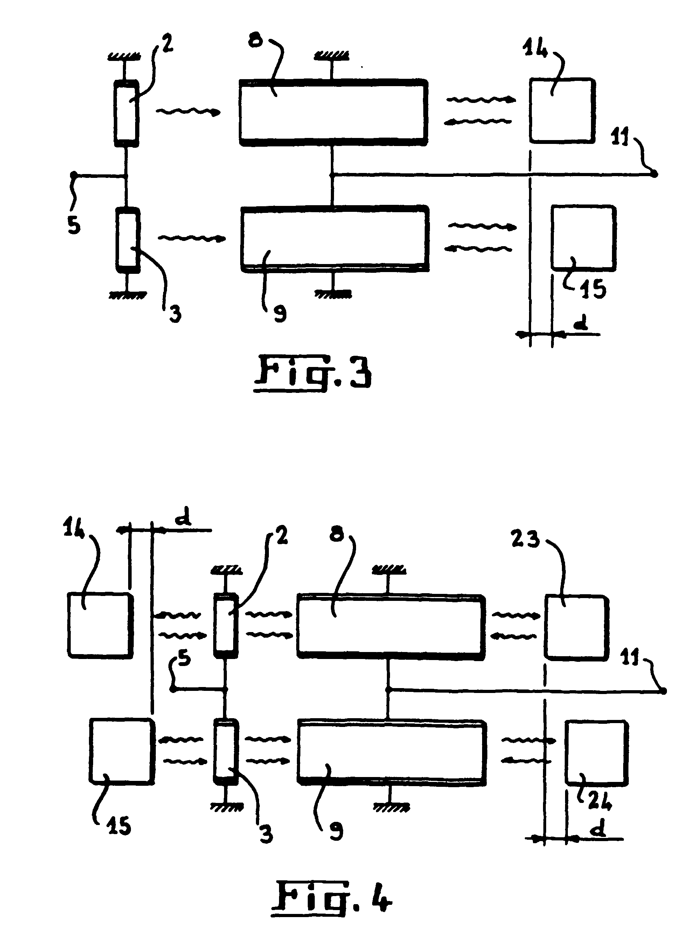

. Figure 3 est une troisième forme de réalisation de filtre ; et

. Figure 4 est une forme de réalisation de filtre à ondes de surface, selon l'invention.

En se référant à la figure 1, il s'agit d'un filtre hyperfréquences à ondes acoustiques de surface qui comporte, sur un même substrat piézoélectrique 1 (entouré en traits mixtes sur cette figure) :

. Deux transducteurs "d'entrée" 2, 3 identiques et de type "court", c'est à dire comportant chacun un très petit nombre de doigts interdigités (deux à trois doigts par exemple) de même longueur. Ces deux transducteurs sont identiques et ils sont, sur le substrat 1, placés symétriquement par rapport à l'axe longitudinal X du substrat 1. Ils sont, dans ce cas de figure, connectés électriquement en parallèle, avec une borne commune 4 reliée électriquement à la borne d'entrée 5 du signal hyperfréquence, et leur autre borne, respectivement 5 et 7, reliée à la masse.

. Deux transducteurs "de sortie" 8, 9, qui sont des transducteurs pondérés de type "long" et de mêmes dimensions. Ces deux transducteurs, dont les pondérations respectives sont déterminées comme on le verra ci-après par la fonction de transfert souhaitée, sont eux-aussi placés symétriquement par rapport à l'axe X et ne sont donc pas décalés dans le sens longitudinal l'un par rapport à l'autre. Ils sont, dans ce cas de figure, connectés électriquement en parallèle, avec une borne commune 10 reliée électriquement à la borne de sortie 11 du filtre, et leur autre borne, respectivement 12 et 13, reliée à la masse.

. Deux réflecteurs d'ondes acoustiques de surface 14 et 15 qui sont placés de part et d'autre de l'axe longitudinal X, à égales distances de celui-ci, mais qui sont décalés l'un par rapport à l'autre et dans le sens longitudinal d'une distance d égale au quart de la longueur d'onde $\lambda$ de propagation des ondes acoustiques de surface. Le réflecteur 14 est associé au transducteur 2 et il est de ce fait aligné longitudinalement avec celui-ci et placé, par rapport à ce transducteur d'entrée 2, à l'opposé du transducteur de sortie 8. De même façon, le réflecteur 15 est associé au transducteur 3 et il est de ce fait aligné longitudinalement avec lui et placé, par rapport à ce deuxième transducteur d'entrée 3 à l'opposé du deuxième transducteur de sortie 9 : en fin de compte, les éléments 14, 2, 8, sont alignés dans le sens longitudinal (c'est à dire selon le sens de propagation des ondes acoustiques de surface), et il en est de même pour les trois autres éléments 15, 3, 9, tandis que ces deux "trios" respectifs 14, 2, 8 et 15, 3, 9 sont placés de part et d'autre de l'axe longitudinal X.

Le fonctionnement du filtre de la figure 1 est le suivant :

En réponse au signal électrique hyperfréquence qui est appliqué en 5 aux transducteurs d'entrée 2 et 3, le transducteur 2 engendre une onde acoustique de surface 25 vers la droite, en direction du transducteur 8, et une autre onde acoustique de surface 26 vers la gauche, en direction du réflecteur 14, tandis que, de la même façon, le transducteur 3 engendre une onde acoustique de surface 17 vers la droite, en direction du transducteur 9, et une autre onde acoustique de surface 18 vers la gauche, en direction du réflecteur 15.

Les ondes directes 25 et 17 sont égales en amplitude et en signe, et sont donc des ondes dites "symétriques". Elles arrivent en phase sur les transducteurs pondérés 8 et 9. La pondération du transducteur 8 est telle que sa réponse temporelle soit définie par une fonction de transfert $h_1$. De même, le transducteur 9 est pondéré de telle sorte que sa réponse temporelle corresponde a une autre fonction de transfert $h_2$. S'agissant d'ondes 25, 17 de type symétrique, il s'ensuit finalement une fonction de transfert hs résultante :

$$hs = h_1 + h_2$$

pour ces deux ondes directes 25 et 17, ce qui correspond à une première partie de réponse impulsionnelle, dont la durée correspond à la longueur commune $X_T$ des deux transducteurs 8 et 9.

Les ondes 26 et 18 sont respectivement réfléchies sur les réflecteurs 14 et 15 pour donner des ondes de retour respectives 19 et 20 qui, en raison du décalage d précité, sont déphasées l'une par rapport à l'autre d'une demi-longueur d'onde et qui, en conséquence, arrivent sur les transducteurs symétriques 2 et 3 en opposition de phase : le couple d'ondes réfléchies 19, 20 est donc de type "antisymétrique" et, comme les transducteurs 2, 3 sont symétriques, ces deux transducteurs sont alors transparents pour ce couple d'ondes réfléchies et leur accès électrique peut être adapté. Le couple d'ondes acoustiques 19, 20 traverse donc, sans absorption notable, le couple de transducteurs 2, 3 et continue son chemin, selon 21 et 22, vers le couple de transducteurs de sortie 8, 9.

Si l'on désigne par $X_{RG}$ la distance longitudinale moyenne entre le couple de transducteurs 2, 3 et le couple de réflecteurs 14, 15, la distance d précitée étant en fait négligeable par rapport à cette dernière, il apparaît donc que les deux ondes réfléchies antisymétriques 21, 22 arrivent sur les transducteurs de sortie 8, 9 avec, par rapport aux ondes directes symétriques 25, 17, un retard correspondant à deux fois le temps nécessaire aux ondes de surface pour parcourir cette distance $X_{RG}$. La fonction de transfert qui résulte de ces deux ondes 21, 22 est une fonction :

$$h_A = h_1 - h_2$$

et, considérée seule, elle a également une durée, en réponse impulsionnelle, qui correspond à la longueur $X_T$ précitée.

Finalement, la réponse impulsionnelle du filtre se compose :

.    d'une première courbe de réponse, de durée correspondant à 2 $X_{RG}$, qui est celle de la fonction hs précitée seule ;

.    puis, dans l'intervalle de temps compris entre 2 $X_{RG}$ et $X_T$, d'une deuxième courbe correspondant à la somme des fonctions hs et $h_A$ précitées, car les ondes directes 25, 17 et réfléchies 21, 22 agissent alors ensemble sur les transducteurs 8 et 9 ;

.    finalement, dans le dernier intervalle de temps qui est compris entre $X_T$ et $X_T$ + 2 $X_{RG}$, où les ondes réfléchies 21, 22 restent seules en présence, d'une troisième courbe de réponse impulsionnelle correspondant à la fonction $h_A$ précitée seule.

De ces trois réponses partielles successives se déduit la réponse impulsionnelle totale du filtre, qui est donc allongée de 2 $X_{RG}$ par rapport à la réponse $X_T$ d'un filtre classique sans réflecteurs.

Il va de soi que les pondérations respectives des transducteurs de sortie 8, 9, qui sont nécessaires pour obtenir la réponse impulsionnelle souhaitée, sont déterminées par le raisonnement inverse : connaissant cette courbe de réponse impulsionnelle, on dessine tout d'abord les deux courbes de réponse $h_A$ et hs dont la composition, en temps et amplitudes, donne cette réponse impulsionnelle. On en déduit ensuite les fonctions de transfert $h_1$ et $h_2$ des transducteurs 8 et 9, et donc les pondérations respectives à appliquer à ces deux transducteurs, par simple application des formules :

$$h_1 = \frac{h_S + h_A}{2}$$

et

$$h_2 = \frac{h_S - h_A}{2}$$

Il convient à ce stade de bien noter qu'un filtre tel que celui de la figure 1 ne fonctionne correctement que parce qu'il comporte un couple de réflecteurs, un couple de transducteurs d'entrée, et un couple de transducteurs de sortie et qu'il est donc constitué selon une structure bi-voies. Un filtre qui ne comporterait qu'un seul transducteur d'entrée, par exemple 2, qu'un seul réflecteur, 14 dans cet exemple, et qu'un seul transducteur de sortie, 8 dans cet exemple, et qui serait donc réalisé en structure uni-voie, ne saurait être utilisé de façon satisfaisante pour les deux principales raisons suivantes :

. l'efficacité du transducteur court, 2 dans cet exemple, devrait être très faible pour que les ondes acoustiques réfléchies puissent le traverser sans que la quasi-totalité de leur énergie soit absorbée dans l'impédance électrique reliée à ce transducteur ;
. les réponses "directe" et "réfléchie" ne seraient pas indépendantes puisque la deuxième est une réplique de la première : la réponse impulsionnelle résultante ne peut pas, comme c'est le cas pour le filtre de la figure 1, être commandée en tout point.

En revenant à la figure 1, on a supposé dans ce qui précède que la borne 5 était la borne d'entrée du filtre et la borne 11 sa borne de sortie. La demanderesse a pu observer que, par une raison de réversibilité qui se conçoit très bien pour un filtre de ce type, ce filtre fonctionne également en sens inverse, c'est à dire en appliquant le signal électrique d'entrée sur la borne 11 et en prélevant son signal électrique de sortie sur la borne 5.

Par ailleurs, ce qui se conçoit aussi très aisément, il est possible de brancher les transducteurs d'entrée 2, 3, ainsi que les transducteurs de sortie 8, 9, en série et non en parallèle. Un tel mode de réalisation est représenté d'ailleurs, à titre indicatif, sur la figure 2 qui sera décrite ci-après. De même, les transducteurs 2, 3 peuvent être branchés en parallèle et les transducteurs 8, 9 en série, ou vice-versa.

La figure 2 représente, une variante du filtre de la figure 1 où, non seulement les couples respectifs de transducteurs 2, 3 et 8, 9 sont connectés en série et non pas en parallèle, mais encore ce sont les deux transducteurs courts 2, 3 qui sont décalés l'un par rapport à l'autre de d = λ/4, et non pas les réflecteurs 14, 15 qui sont alors alignés dans le sens transversal. Préférentiellement dans un tel cas, afin de garder égales les distances longitudinales entre les transducteurs 2 et 8 d'une part et 3 et 9 d'autre part, les transducteurs longs 8 et 9 sont alors décalés, l'un par rapport à l'autre, de d dans le même sens que les transducteurs 2 et 3. Le fonctionnement de ce filtre est bien entendu identique à celui de la figure 1, hs restant d'une manière générale la réponse à un couple d'ondes 25, 17 émis par les transducteurs d'entrée 2, 3, tandis que $h_A$ est la réponse obtenue lorsque l'onde de la voie acoustique inférieure du couple émis est changée de signe par un déphasage d'une demi-longueur d'onde.

Comme il va de soi, la distance de décalage d précitée et égale à λ/4 à un nombre entier de demi-longueurs d'onde près, c'est à dire :

$$d = (n + 1/2)\lambda/2$$

où n est un nombre entier.

La figure 3 montre un filtre qui se différencie de celui de la figure 1 par le fait que les réflecteurs 14 et 15, qui sont toujours décalés longitudinalement, sont associés aux transducteurs longs "de sortie" 8, 9 au lieu d'être associés aux transducteurs courts "d'entrée" 2, 3. La demanderesse a pu observer qu'un tel filtre fonctionnait lui aussi de manière satisfaisante, en procurant donc un allongement de la réponse impulsionnelle tout en permettant un modelage aisé de celle-ci.

Enfin, la figure 4 montre un filtre selon l'invention qui est une combinaison des filtres selon les figures 1 et 3. Ce filtre présente deux couples de réflecteurs au lieu d'un seul :

. un premier couple de réflecteurs 14, 15 qui sont associés aux transducteurs courts 2, 3 et qui, à l'instar de ceux de la figure 1, sont décalés longitudinalement l'un par rapport à l'autre de la distance d précitée ; et
. un deuxième couple de réflecteurs 23, 24 qui sont associés aux transducteurs longs 8, 9 et qui, à l'instar de la figure 3, sont eux-aussi décalés longitudinalement l'un par rapport à l'autre d'un quart de la longueur d'onde de propagation des ondes acoustiques de surface.

Comme il va de soi, l'invention n'est pas limitée à l'exemple de réalisation qui vient d'être décrit, mais elle est bien au contraire susceptible d'être réalisée sous bien d'autres formes équivalentes, même en mode dégradé (c'est à dire en correspondant pas à la forme préférentielle décrite ci-dessus).

**Revendications**

1. Filtre à ondes a ondes acoustiques de surface, constitué selon une structure bi-voies (14,2,8 et 15,3,9) comprenant chacune respectivement un transducteur d'entrée (2,3) connecté électriquement à la borne d'entrée (5) du filtre, un transducteur de sortie (8, 9) connecté électriquement à la borne de sortie (11) du filtre, ce transducteur d'entrée (2,3) étant directement connecté acoustiquement à ce transducteur de sortie (8,9), caractérisé en ce que les transducteurs de sortie ont des pondérations différentes, en ce qu'il comprend en outre dans chaque voie un réflecteur d'ondes de surface (14,15) directement connecté acoustiquement au transducteur (2,3) d'entrée de la voie, en ce que les deux distances respectives qui correspondent chacune au trajet acoustique direct (26,18) entre ce réflecteur (14,15) et le transducteur (2,3) auquel il est directement connecté acoustiquement, diffèrent, à un nombre entier de demi-longueurs d'onde (λ) de propagation des ondes de surface près, d'un quart de longueur d'onde (λ) pour rendre transparents les transducteurs d'entrée aux ondes réfléchies par les réflecteurs, et en ce qu'il comporte en outre un deuxième couple de réflecteurs (23,24) qui est associé au couple de transducteurs (8,9) auquel le premier couple de réflecteurs précité (14,15) n'est pas associé, ces deux autres réflecteurs (23,24) étant eux-aussi décalés longitudinalement l'un par rapport à l'autre d'une distance (d) qui est égale au quart de la longueur d'onde (λ) de propagation des ondes acoustiques de surface, à un nombre entier de demi-longueurs d'onde près.

2. Filtre à ondes de surface selon la revendication 1, caractérisé en ce que les deux transducteurs d'entrée (2,3) sont identiques.

3. Filtre à ondes acoustiques de surface selon la revendication 1 ou la revendication 2, caractérisé en ce que les distances qui séparent chacun des transducteurs d'entrée (2,3) du transducteur de sortie (8,9) qui lui est acoustiquement associé sont égales.

4. Filtre à ondes de surface selon l'une des revendications 1 à 3, caractérisé en ce que les transducteurs d'entrée sont des transducteurs (2,3) de type court.

5. Filtre à ondes de surface selon la revendication 4, caractérisé en ce que les transducteurs de sortie (8,9) sont des transducteurs pondérés de type long, dont les pondérations respectives sont choisies pour conférer au filtre la courbe de réponse impulsionnelle souhaitée.

6. Filtre à ondes de surface selon l'une des revendications 1 à 5, caractérisé en ce que les deux transducteurs d'entrée (2,3) sont symétriques par rapport à l'axe longitudinal (X) du filtre.

7. Filtre à ondes de surface selon l'une des revendications 1 à 6, caractérisé en ce que les deux transducteurs de sortie (8,9) sont des transducteurs de mêmes dimensions.

8. Filtre à ondes de surface selon l'une des revendications 1 à 7, caractérisé en ce que les deux transducteurs de sortie (8,9) sont disposés symétriquement par rapport à l'axe longitudinal (X) du filtre.

**Patentansprüche**

1. Oberflächenschallwellen-Filter, das gemäß einer Struktur mit zwei Wegen (14, 2, 8 und 15, 3, 9) gebildet ist, von denen jeder einen Eingangswandler (2, 3), der mit dem Eingangsanschluß des Filters elektrisch verbunden ist und einen Ausgangswandler (8, 9), der mit dem Ausgangsanschluß (11) des Filters elektrisch verbunden ist, enthält, wobei dieser Eingangswandler (2, 3) akustisch direkt mit diesem Ausgangswandler (8, 9) verbunden ist, dadurch gekennzeichnet, daß die Ausgangswandler unterschiedliche Gewichtungen aufweisen, daß es außerdem in jedem Weg einen Oberflächenwellen-Reflektor (14, 15) enthält, der mit dem Eingangswandler (2, 3) des Weges akustisch direkt verbunden ist, und daß sich die beiden jeweiligen Strekken, die jedem der direkten Schallwege (26, 18) zwischen diesem Reflektor (14, 15) und dem Wandler (2, 3), mit dem er akustisch direkt verbunden ist, bis auf ein ganzzahliges Vielfaches der Ausbreitungswellenlänge (λ) der Oberflächenwellen um eine Viertelwellenlänge (λ) unterscheiden, um die Eingangswandler für die von den Reflektoren reflektierten Wellen durchlässig zu machen und daß es außerdem ein zweites Paar von Reflektoren (23. 24) enthält, das dem Paar von Wandlern (8, 9) zugeordnet ist, dem das obenerwähnte erste Paar von Reflektoren (14, 15) nicht zugeordnet ist, wobei diese beiden anderen Reflektoren (23, 24) ihrerseits in Längsrichtung zueinander um eine Strecke (d) versetzt sind, die bis auf ein ganzzahliges Vielfaches der Halbwellenlängen gleich einem Viertel der Ausbreitungswellenlänge (λ) der Oberflächenschallwellen ist.

2. Oberflächenwellen-Filter gemäß Anspruch 1, dadurch gekennzeichnet, daß die beiden Eingangswandler (2, 3) identisch sind.

3. Oberflächenschallwellen-Filter gemäß Anspruch 1 oder Anspruch 2, dadurch gekennzeichnet, daß die Strecken, die jeden der Eingangswandler (2, 3) von dem ihm akustisch zugeordneten Ausgangswandler (8, 9) trennen, gleich sind.

4. Oberflächenwellen-Filter gemäß einem der Ansprüche 1 bis 3, dadurch gekennzeichnet, daß die Eingangswandler Wandler (2, 3) vom kurzen Typ sind.

5. Oberflächenwellen-Filter gemäß Anspruch 4, dadurch gekennzeichnet, daß die Ausgangswandler (8, 9) gewichtete Wandler vom langen Typ sind, deren jeweilige Gewichtungen so gewählt sind, daß dem Filter die gewünschte Impuls-Ansprechkurve verliehen wird.

6. Oberflächenwellen-Filter gemäß einem der Ansprüche 1 bis 5, dadurch gekennzeichnet, daß die beiden Eingangswandler (2, 3) in bezug auf die Längsachse (X) des Filters symmetrisch sind.

7. Oberflächenwellen-Filter gemäß einem der Ansprüche 1 bis 6, dadurch gekennzeichnet, daß die beiden Ausgangswandler (8, 9) Wandler mit gleichen Abmessungen sind.

8. Oberflächenwellen-Filter gemäß einem der Ansprüche 1 bis 7, dadurch gekennzeichnet, daß die beiden Ausgangswandler (8, 9) in bezug auf die Längsachse (X) des Filters symmetrisch angeordnet sind.


**Claims**

1. Surface acoustic wave filter, constituted according to a two-channel structure (14, 2, 8 and 15, 3, 9), each channel comprising respectively an input transducer (2, 3) electrically connected up to the input terminal (5) of the filter, an output transducer (8, 9) electrically connected up to the output terminal (11) of the filter, this input transducer (2, 3) being acoustically connected up directly to this output transducer (8, 9), characterised in that the output transducers have different weightings, in that it furthermore comprises, in each channel, a surface-wave reflector (14, 15) acoustically connected up directly to the input transducer (2, 3) of the channel in that the two respective distances, each of which corresponds to the direct acoustic path (26, 18) between this reflector (14, 15) and the transducer (2, 3) to which it is acoustically connected up directly, differ, to within an integral number of halves of the surface-wave propagation wavelength (λ), by a quarter of the wavelength (λ) in order to make the input transducers transparent to the waves reflected by the reflectors, and in that it furthermore comprises a second pair of reflectors (23, 24) which is associated with the pair of transducers (8, 9) with which pair the aforementioned first pair of reflectors (14, 15) is not associated, these two other reflectors (23, 24) themselves being also longitudinally offset one with respect to the other by a distance (d) which is equal to quarter of the surface acoustic wave propagation wavelength (λ), within an integral number of half wavelengths.

2. Surface acoustic wave filter according to Claim 1, characterised in that the two input transducers (2, 3) are identical.

3. Surface acoustic wave filter according to Claim 1 or Claim 2, characterised in that the distances which separate each of the input transducers (2, 3) from the output transducer (8, 9), with which it is acoustically associated, are equal.

4. Surface-wave filter according to one of Claims 1 to 3, characterised in that the input transducers are short-type transducers (2, 3).

5. Surface-wave filter according to Claim 4, characterised in that the output transducers (8, 9) are long-type weighted transducers, the respective weightings of which are chosen in order to confer on the filter the desired impulse-response curve.

6. Surface-wave filter according to one of Claims 1 to 5, characterised in that the two input transducers (2, 3) are symmetric with respect to the longitudinal axis (X) of the filter.

7. Surface-wave filter according to one of Claims 1 to 6, characterised in that the two output transducers (8, 9) are same-size transducers.

8. Surface-wave filter according to one of Claims 1 to 7, characterised in that the two output transducers (8, 9) are disposed symmetrically with respect to the longitudinal axis (X) of the filter.

Fig.1

Fig. 2

Fig. 3

Fig. 4